# EUROPEAN PATENT SPECIFICATION

(11) **EP 4 254 830 B1**
(45) Date of publication and mention of the grant of the patent: **08.07.2026**
(21) Application number: 23176514.0
(22) Date of filing: 07.09.2015
(51) Int. Cl.: H03G 3/02, H04R 3/00, H04H 60/04, G06F 3/0482, G06F 3/16, G06F 3/04847

(54) **PROGRAM READABLE BY COMPUTER, AND SOUND VOLUME OPERATING DEVICE**
DURCH EINEN COMPUTER LESBARES PROGRAMM UND TONLAUTSTÄRKEBEDIENUNGSVORRICHTUNG
PROGRAMME APTE À ÊTRE LU PAR ORDINATEUR, ET DISPOSITIF DE COMMANDE DE VOLUME SONORE

(30) Priority: 08.12.2014 JP 2014248151
(43) Date of publication of application: 04.10.2023
(62) Divisional of application: 15867507.4
(73) Proprietor: D&M Holdings Inc., Kawasaki-shi Kanagawa 210-8569 (JP)
(72) Inventor: FUKUSHIMA, Hiroshi, Kanagawa, 210-8569 (JP)
(74) Representative: Mewburn Ellis LLP

(56) References cited:
- US-A1- 2012 057 725
- US-A1- 2013 121 510
- US-A1- 2014 079 247

## Description

### Technical Field

The present invention relates to a technology for receiving volume level control for a plurality of audio devices. In particular, the present invention relates to a method for adjusting volume levels of a plurality of audio devices, a program readable by a computer, and a volume level control device.

### Background Art

Hitherto, there has been known a volume level control device capable of individually or collectively adjusting volume levels of a plurality of audio devices. For example, in a multi-zone system disclosed in Patent Literature 1, a controller displays on a graphical user interface a control screen including a plurality of channel faders (audio volumes) associated with a plurality of multimedia players belonging to a zone group, respectively, and a master fader (group audio volume). The "channel fader" is a linear fader for individually receiving volume level control for a multimedia player associated with this channel fader. The controller outputs, to the multimedia player associated with the channel fader, a control signal for adjusting a volume level of the associated multimedia player to a volume level corresponding to a scale value indicated by this channel fader. Further, the "master fader" is a linear fader for collectively receiving volume level control for a plurality of multimedia players belonging to a zone group. The controller collectively moves all of the channel faders in the control screen in the same direction as a movement direction of the master fader along with movement of the master fader while keeping the difference between the scale values indicated by those channel faders (difference in volume level). In this system, the master fader is set to be arranged at a position indicating an averaged or median value of the scale values indicated by the plurality of channel faders in the control screen, respectively.

### Citation List

### Patent Literature

[PTL 1] US 7571014 B1

US 2012/057725 A1 describes a control terminal apparatus including a transmission unit transmitting a control signal to audio output apparatuses, a display unit, an operation detector detecting an operation associated with display content, and a controller displaying individual volume setting sections which correspond to the audio output apparatuses and which include operation members performing variable operations of volume settings while volume setting states are displayed, displaying a master volume setting section including an operation member performing collective variable operation while the volume balance of the audio output apparatuses is maintained, executing clear display of a setting changeable range in which the volume balance is maintained in the master volume setting section, generating, when the operation detector detects an operation performed on one of the individual volume setting sections or the master volume setting section, a control signal corresponding to content of the operation, and causing the transmission unit to transmit the control signal.

US 2013/121510 A1 describes a controlling terminal apparatus including a transmission section transmitting and outputting a control signal to a plurality of sound outputting apparatus; a display section; an operation detection section detecting an operation for the displayed substance of the display section; and a control section controlling the display section to display, for each of the sound outputting apparatus, an individual sound volume setting region and a master sound volume setting region, the control section changing, when an operation for the master sound volume setting region is detected by the operation detection section, the sound volume setting of each of the individual sound volume setting regions using a value with respect to an operable amount of each of the individual sound volume setting regions, generating control signals indicative of the new sound volume settings, and controlling the transmission section to transmit and output the control signals.

US 2014/079247 A1 describes techniques for controlling the volumes of multiple audio output devices using a collective (master) volume control and an individual volume control for each audio output device.

### Summary of Invention

### Technical Problem

As described above, in a multi-zone system disclosed in Patent Literature 1, the controller collectively moves all of the channel faders in the control screen in the same direction as the movement direction of the master fader along with the movement of the master fader while keeping the difference between the scale values indicated by those channel faders (that is, a positional relationship among those channel faders). In this system, the master fader is arranged at the position indicating the averaged or median value of the scale values indicated by the plurality of channel faders in the control screen, respectively. Accordingly, the movement of the master fader is stopped at a position of a scale value that is indicated by the master fader when a channel fader that indicates the minimum scale value among the plurality of channel faders in the control screen reaches a lower limit value of a scale. Similarly, the movement of the master fader is stopped at a position of a scale value that is indicated by the master fader when a channel fader that indicates the maximum scale value among the plurality of channel faders in the control screen reaches an upper limit value of the scale.

Therefore, despite the fact that the master fader does not reach the lower limit value or the upper limit value of the scale, the user cannot further move the master fader in a direction approaching the lower limit value or the upper limit value of the scale. It is thus difficult to intuitively grasp a range in which the master fader is movable on the scale. Moreover, all of the channel faders in the control screen cannot be moved to the lower limit value or the upper limit value of the scale only through the operation on the master fader, and hence it is necessary to individually operate those channel faders.

The present invention has been made in view of the circumstances described above, and it is an object of the present invention to improve operability of volume level control for a plurality of audio devices.

### Solution to Problem

Accordingly, there is provided a method for adjusting volume levels of a plurality of audio devices, a program readable by a computer, the program configured to cause the computer to function as a volume level control device and a volume level control device, which is configured to adjust volume levels of a plurality of audio devices according to the independent claims. In order to solve the problems described above, according to one embodiment of the present invention, a minimum-value side end portion, which is one end portion of a master fader, is displayed at a position indicating the same scale value as a minimum value of scale values indicated by a plurality of channel faders in a control screen, respectively, and a maximum-value side end portion, which is another end portion of the master fader, is displayed at a position indicating the same scale value as a maximum value of the scale values indicated by the plurality of channel faders in the control screen, respectively, such that the master fader has a width corresponding to the minimum value and the maximum value of the scale values indicated by the plurality of channel faders in the control screen, respectively. With this configuration, when a channel fader indicating the minimum scale value among the plurality of channel faders in the control screen reaches a lower limit value of a scale, the minimum-value side end portion of the master fader also reaches a lower limit value of a scale, and when a channel fader indicating the maximum scale value among the plurality of channel faders in the control screen reaches an upper limit value of the scale, the maximum-value side end portion of the master fader also reaches an upper limit value of the scale.

In this case, when an operation of moving the maximum-value side end portion of the master fader toward the lower limit value of the scale is received under a state in which the minimum-value side end portion of the master fader has reached the lower limit value of the scale, a channel fader that has not reached the lower limit value of the scale among the plurality of channel faders in the control screen may be moved toward the lower limit value of the scale along with the movement of the maximum-value side end portion of the master fader. As another configuration, when a predetermined operation is performed on the master fader under the state in which the minimum-value side end portion of the master fader has reached the lower limit value of the scale, every channel fader that has not reached the lower limit value of the scale among the plurality of channel faders in the control screen may be moved to the lower limit value of the scale.

As still another configuration, when an operation of moving the minimum-value side end portion of the master fader toward the upper limit value of the scale is received under a state in which the maximum-value side end portion of the master fader has reached the upper limit value of the scale, a channel fader that has not reached the upper limit value of the scale among the plurality of channel faders in the control screen may be moved toward the upper limit value of the scale along with the movement of the minimum -value side end portion of the master fader. As yet another configuration, when a predetermined operation is performed on the master fader under the state in which the maximum-value side end portion of the master fader has reached the upper limit value of the scale, every channel fader that has not reached the upper limit value of the scale among the plurality of channel faders in the control screen may be moved to the upper limit value of the scale.

### Solution to Problem

For example, according to one embodiment of the present invention, there is provided a program readable by a computer, the program causing the computer to function as a volume level control device,
the volume level control device including:
   volume control receiving means for displaying, on a graphical user interface, a control screen including a plurality of channel faders for individually receiving volume level control for a plurality of audio devices and a master fader for collectively receiving volume level control for the plurality of audio devices, to thereby receive volume level control for the plurality of audio devices; and
   control signal outputting means for outputting, for each of the plurality of channel faders, a control signal for adjusting a volume level of one of the plurality of audio devices associated with the each of the plurality of channel faders to a volume level corresponding to a scale value indicated by the each of the plurality of channel faders,
in which the volume control receiving means is configured to move, in the control screen, the plurality of channel faders in the same direction as a movement direction of the master fader along with movement of the master fader while keeping a difference between the scale values indicated by the plurality of channel faders,
in which the master fader has a width corresponding to a minimum value and a maximum value of the scale values indicated by the plurality of channel faders, respectively, and
in which the master fader has a minimum-value side end portion displayed at a position indicating the same scale value as the minimum value and has a maximum-value side end portion displayed at a position indicating the same scale value as the maximum value, the minimum-value side end portion being one end portion of the master fader, the maximum-value side end portion being another end portion of the master fader.

### Advantageous Effects of Invention

According to the present invention, when the channel fader indicating the minimum scale value among the plurality of channel faders in the control screen reaches the lower limit value of the scale, the minimum-value side end portion of the master fader also reaches the lower limit value of the scale, and when the channel fader indicating the maximum scale value among the plurality of channel faders in the control screen reaches the upper limit value of the scale, the maximum-value side end portion of the master fader also reaches the upper limit value of the scale. Accordingly, the master fader can be moved to the lower limit value and the upper limit value of the scale while keeping a relative balance among the channels, and it is thus easy to intuitively grasp a range in which the master fader is movable on the scale. Therefore, according to the present invention, the operability of volume level control for a plurality of audio devices can be improved.

### Brief Description of Drawings

FIG. 1 is a schematic configuration diagram of an audio system according to an embodiment of the present invention.
FIG. 2 is a schematic functional configuration diagram of a volume level control terminal 2.
FIG. 3 is a flowchart for illustrating an operation of the volume level control terminal 2.
FIG. 4 is a flowchart for illustrating channel fader updating processing (Step S4) illustrated in FIG. 3.
FIG. 5 is a flowchart for illustrating master fader updating processing (Step S6) illustrated in FIG. 3.
FIG. 6 is a diagram for schematically illustrating an example of a control screen 25.
FIG. 7 is a diagram for schematically illustrating an example of the control screen 25 in a state in which a minimum-value side end portion 271 of a master fader 27 has reached a lower limit value of a scale 270.
FIG. 8 is a diagram for schematically illustrating an example of the control screen 25 in a case where a maximum-value side end portion 272 of the master fader 27 is operated to be moved toward the lower limit value of the scale 270 under the state in which the minimum-value side end portion 271 of the master fader 27 has reached the lower limit value of the scale 270.
FIG. 9 is a diagram for schematically illustrating an example of the control screen 25 in a case where the maximum-value side end portion 272 of the master fader 27 is operated to be moved to the lower limit value of the scale 270 under the state in which the minimum-value side end portion 271 of the master fader 27 has reached the lower limit value of the scale 270.
FIG. 10 is a diagram for schematically illustrating an example of the control screen 25 in a state in which the maximum-value side end portion 272 of the master fader 27 has reached an upper limit value of the scale 270.
FIG. 11 is a diagram for schematically illustrating an example of the control screen 25 in a case where the minimum-value side end portion 271 of the master fader 27 is operated to be moved toward the upper limit value of the scale 270 under the state in which the maximum-value side end portion 272 of the master fader 27 has reached the upper limit value of the scale 270.
FIG. 12 is a diagram for schematically illustrating an example of the control screen 25 in a case where the minimum-value side end portion 271 of the master fader 27 is operated to be moved to the upper limit value of the scale 270 under the state in which the maximum-value side end portion 272 of the master fader 27 has reached the upper limit value of the scale 270.

### Description of Embodiments

In the following, a description is given of an embodiment of the present invention with reference to the drawings.

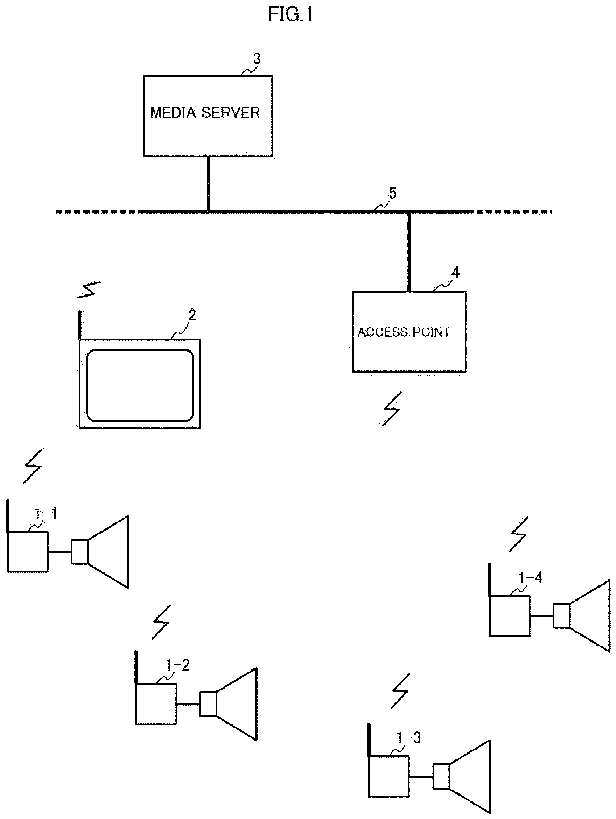

FIG. 1 is a schematic configuration diagram of an audio system according to this embodiment.

As illustrated in FIG. 1, the audio system according to this embodiment includes a plurality of wireless network-compatible speakers 1-1 to 1-4 (hereinafter sometimes referred to simply as "wireless network-compatible speaker 1"), a volume level control terminal 2, and a media server 3 connected to a network 5. Each of the wireless network-compatible speakers 1 is connected to the network 5 via an access point 4, and is configured to acquire audio data from the media server 3 and play back the audio data for output. The volume level control terminal 2 is compatible with a wireless network, and is configured to adjust, via the access point 4, a volume level of each wireless network-compatible speaker 1 in accordance with volume level control performed by a user.

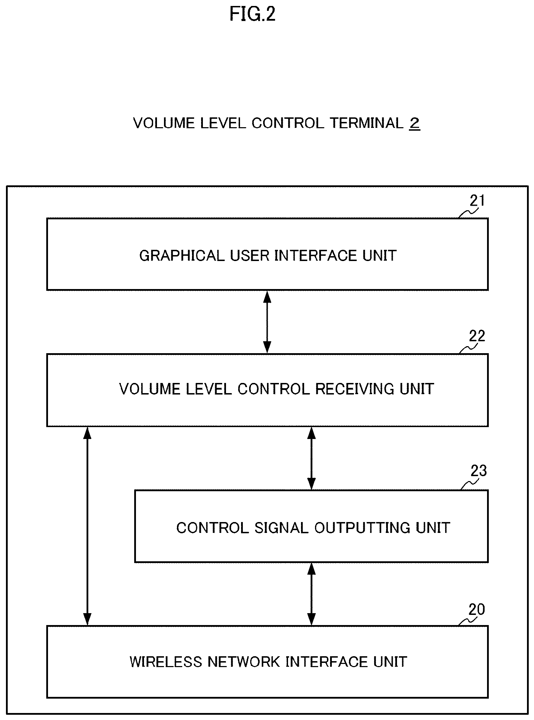

FIG. 2 is a schematic functional configuration diagram of the volume level control terminal 2. A functional configuration of the volume level control terminal 2 illustrated in FIG. 2 is implemented in the following manner. Specifically, for example, in a smartphone, a tablet PC, a PDA, a cellular phone, or other such computer including a CPU, a memory, an SSD or other such auxiliary storage device, a touch panel, a display, a pointing device or other such input/output device, and a wireless LAN adapter or other such communication device, the CPU loads a predetermined program onto the memory from the auxiliary storage device for execution.

As illustrated in FIG. 2, the volume level control terminal 2 includes a wireless network interface unit 20, a graphical user interface unit 21, a volume level control receiving unit 22, and a control signal outputting unit 23.

The wireless network interface unit 20 is an interface for communicating, via the access point 4, to/from the wireless network-compatible speaker 1 and to/from the media server 3 connected to the network 5.

The graphical user interface unit 21 is an interface for displaying information and receiving various types of operations from the user.

The volume level control receiving unit 22 is configured to receive volume level control for the wireless network-compatible speaker 1 from the user via the graphical user interface unit 21.

The control signal outputting unit 23 is configured to output a control signal for adjusting a volume level to the wireless network-compatible speaker 1 via the wireless network interface unit 20.

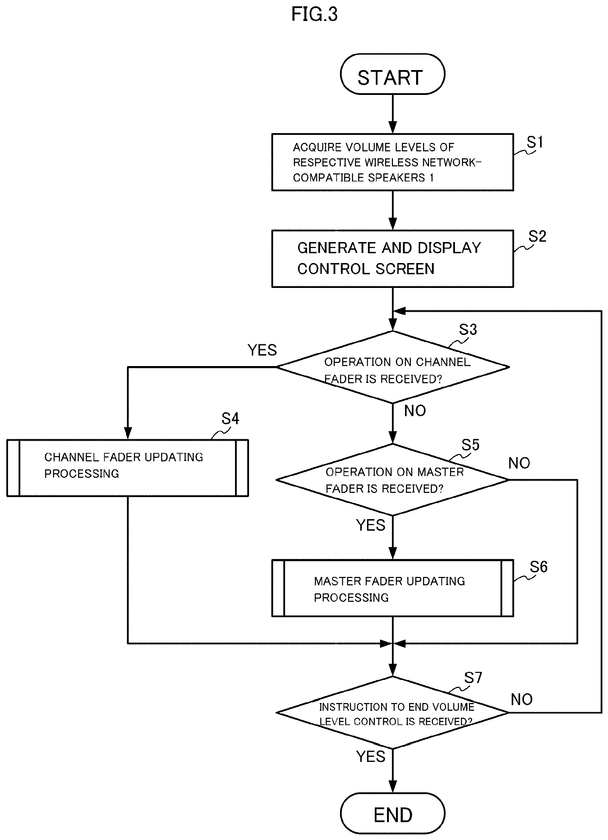

FIG. 3 is a flowchart for illustrating an operation of the volume level control terminal 2. This flow is started when the volume level control receiving unit 22 receives an instruction to start volume level control from the user via the graphical user interface unit 21.

First, the volume level control receiving unit 22 acquires volume levels from the respective wireless network-compatible speakers 1 via the wireless network interface unit 20 (Step S1). Instead of acquiring the volume levels from the respective wireless network-compatible speakers 1, the volume level of each wireless network-compatible speaker 1, which is identified based on a control signal output last by the volume level control terminal 2, may be stored for each wireless network-compatible speaker 1, to thereby acquire the volume level of each wireless network-compatible speaker 1.

Next, the volume level control receiving unit 22 uses the volume levels of the respective wireless network-compatible speakers 1 to generate a control screen 25 for receiving volume level control for the wireless network-compatible speakers 1 from the user, and displays the control screen 25 on the graphical user interface unit 21 (Step S2).

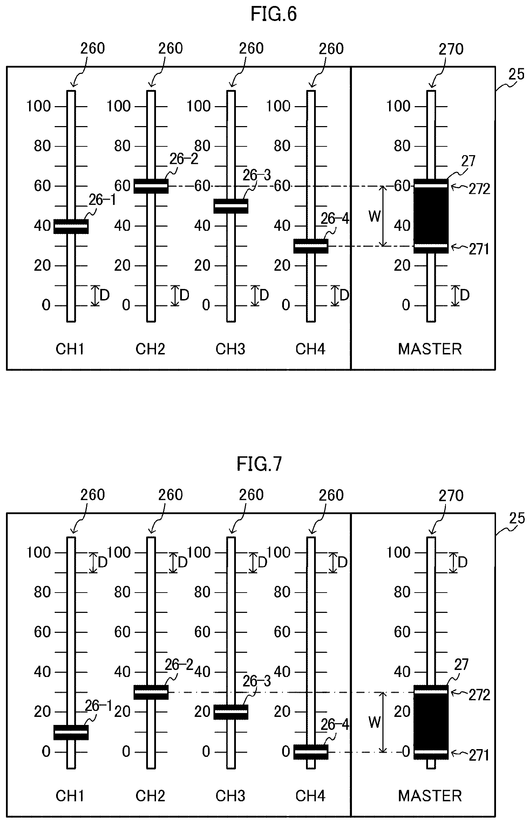

FIG. 6 is a diagram for schematically illustrating an example of the control screen 25. As illustrated in FIG. 6, the control screen 25 includes a plurality of channel faders 26-1 to 26-4 (hereinafter sometimes referred to simply as "channel fader 26") for individually receiving volume level control for the associated wireless network-compatible speaker 1 and a master fader 27 for collectively receiving volume level control for all of the wireless network-compatible speakers 1. It is assumed in this case that the channel fader 26-1 for CH1, the channel fader 26-2 for CH2, the channel fader 26-3 for CH3, and the channel fader 26-4 for CH4 are associated with the wireless network-compatible speaker 1-1, the wireless network-compatible speaker 1-2, the wireless network-compatible speaker 1-3, and the wireless network-compatible speaker 1-4, respectively. The user may be allowed to select the wireless network-compatible speaker 1 for which the associated channel fader 26 is displayed on the control screen 25 one by one from among the wireless network-compatible speakers 1 forming the audio system, or may be allowed to select a plurality of such network-compatible speakers 1 collectively. As another configuration, a group setting in which the plurality of wireless network-compatible speakers 1 forming the audio system are grouped into one or more groups may be stored so that the channel faders 26 corresponding to the wireless network-compatible speakers 1 forming a group selected by the user from among the groups defined in this group setting may be displayed on the control screen 25.

On the control screen 25, each of the channel faders 26 is arranged at a position of a scale value on a corresponding scale 260 that is indicated by the channel fader 26, and in accordance with an operation on the channel fader 26 or the master fader 27, slides along the corresponding scale 260 within a scale range (from an upper limit value to a lower limit value) of the scale 260. Meanwhile, the master fader 27 is arranged at a position on a corresponding scale 270, and slides or expands/contracts along the corresponding scale 270 within a scale range (from an upper limit value to a lower limit value) of the scale 270 in accordance with an operation on the master fader 27 or any one of the channel faders 26. The master fader 27 has a width W corresponding to a minimum value and a maximum value of the scale values indicated by the respective channel faders 26. The master fader 27 has one end portion (hereinafter referred to as "minimum-value side end portion") 271 displayed at a position of the same scale value as the minimum value and has another end portion (hereinafter referred to as "maximum-value side end portion") 272 displayed at a position of the same scale value as the maximum value. In FIG. 6, a scale value "30" indicated by the channel fader 26-4 is the minimum value, and a scale value "60" indicated by the channel fader 26-2 is the maximum value. Thus, the minimum-value side end portion 271 and the maximum-value side end portion 272 of the master fader 27 indicate the scale value "30" and the scale value "60", respectively.

In this case, the scale 260 of each channel fader 26 and the scale 270 of the master fader 27 have the same scale range of from a common upper limit value to a common lower limit value (in FIG. 6, from a lower limit value of 0 to an upper limit value of 100) and the same scale interval D, and the same scale values of all of the scales 260 and 270 are arranged so as to be aligned in line in a predetermined direction (in FIG. 6, a horizontal direction). In this embodiment, as the scale 260 of each channel fader 26 and the scale 270 of the master fader 27, vertical scales in which the same scale values are arranged so as to be aligned in line in the horizontal direction are used. However, it is also possible to use, for example, horizontal scales in which the same scale values are arranged so as to be aligned in line in a vertical direction or circular scales (rotary knobs) in which the same scale values are arranged at positions of the same central angle.

Next, the volume level control receiving unit 22 waits for a certain operation to be performed by the user via the graphical user interface unit 21 (Step S3). Then, when any one of the channel faders 26 of the control screen 25 is operated ("YES" in Step S3), channel fader updating processing described later is performed (Step S4), and when the master fader 27 is operated ("YES" in Step S5), master fader updating processing described later is performed (Step S6).

Then, when receiving an instruction to end the volume level control from the user via the graphical user interface unit 21 ("YES" in Step S7), the volume level control receiving unit 22 ends this flow.

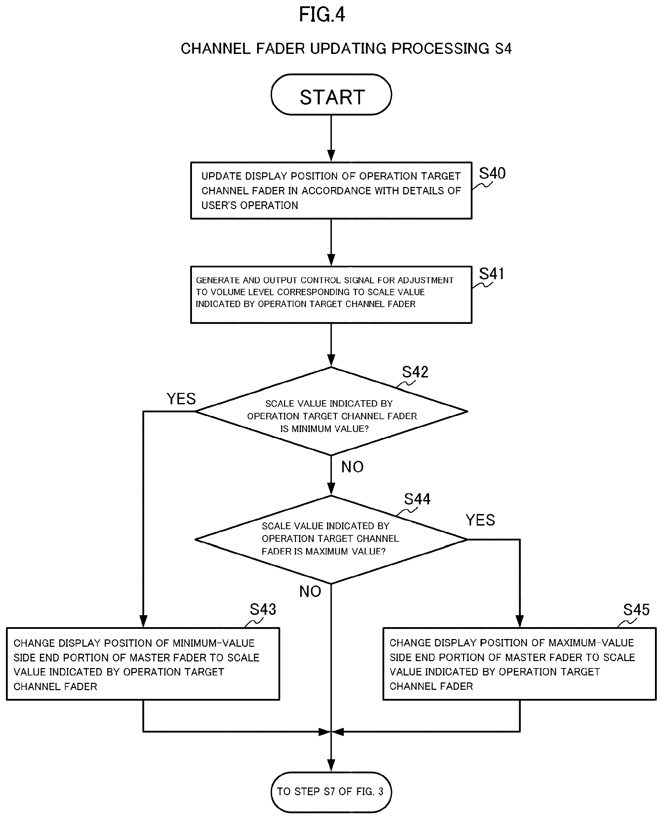

FIG. 4 is a flowchart for illustrating the channel fader updating processing (Step S4) illustrated in FIG. 3.

First, the volume level control receiving unit 22 updates a display position on the scale 260 of the channel fader (hereinafter referred to as "operation target channel fader") 26 operated by the user via the graphical user interface unit 21 in accordance with details of the user's operation (movement direction and movement amount) (Step S40).

Next, the volume level control receiving unit 22 identifies a scale value indicated by the operation target channel fader 26 and notifies the control signal outputting unit 23 of the scale value along with address information on the wireless network-compatible speaker 1 associated with the operation target channel fader 26. In response to this, the control signal outputting unit 23 generates a control signal for adjusting the volume level of the associated wireless network-compatible speaker 1 to a volume level corresponding to the scale value received from the volume level control receiving unit 22. The control signal outputting unit 23 then transmits via the wireless network interface unit 20 the control signal to the wireless network-compatible speaker 1 that is identified by the address information received from the volume level control receiving unit 22 (Step S41).

Next, when the scale value indicated by the operation target channel fader 26 is the minimum value of the scale values indicated by the respective channel faders 26 ("YES" in Step S42), the volume level control receiving unit 22 updates a display position on the scale 270 of the minimum-value side end portion 271 of the master fader 27 to a position of the same scale value as the scale value indicated by the operation target channel fader 26, to thereby change the width W of the master fader 27 (Step S43). After that, the processing proceeds to Step S7 of FIG. 3.

Further, when the scale value indicated by the operation target channel fader 26 is the maximum value of the scale values indicated by the respective channel faders 26 ("YES" in Step S44), the volume level control receiving unit 22 updates a display position on the scale 270 of the maximum-value side end portion 272 of the master fader 27 to a position of the same scale value as the scale value indicated by the operation target channel fader 26, to thereby change the width W of the master fader 27 (Step S45). After that, the processing proceeds to Step S7 of FIG. 3.

On the other hand, when the scale value indicated by the operation target channel fader 26 is neither the minimum value of the scale values indicated by the respective channel faders 26 ("NO" in Step S42) nor the maximum value thereof ("NO" in Step S44), the volume level control receiving unit 22 does not change the width W of the master fader 27, and the processing proceeds to Step S7 of FIG. 3.

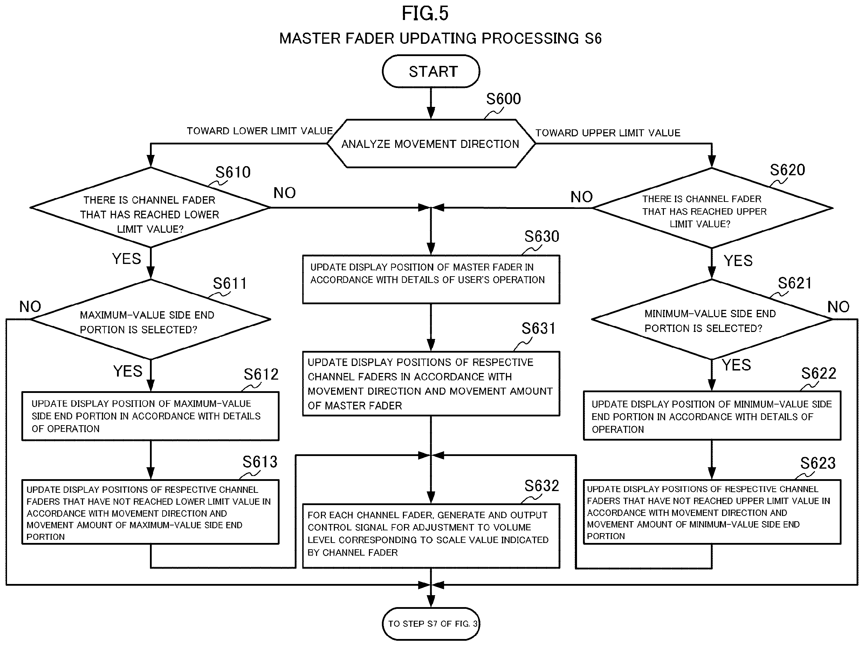

FIG. 5 is a flowchart for illustrating the master fader updating processing (Step S6) illustrated in FIG. 3.

First, the volume level control receiving unit 22 analyzes the movement direction of the master fader 27 operated by the user via the graphical user interface unit 21 (Step S600). When the movement direction of the master fader 27 is a direction toward the lower limit value of the scale 270 ("toward lower limit value" in Step S600), the processing proceeds to Step S610. Then, the volume level control receiving unit 22 examines whether or not, among the channel faders 26-1 to 26-4, there is a channel fader 26 that has reached the position of the lower limit value of the corresponding scale 260. On the other hand, when the movement direction of the master fader 27 is a direction toward the upper limit value of the scale 270 ("toward upper limit value" in Step S600), the processing proceeds to Step S620. Then, the volume level control receiving unit 22 examines whether or not, among the channel faders 26-1 to 26-4, there is a channel fader 26 that has reached the position of the upper limit value of the corresponding scale 260.

When none of the channel faders 26 has reached the position of the lower limit value of the corresponding scale 260 in Step S610 ("NO" in Step S610), or none of the channel faders 26 has reached the position of the upper limit value of the corresponding scale 260 in Step S620 ("NO" in Step S620), the volume level control receiving unit 22 updates the display position on the scale 270 of the master fader 27 in accordance with details of the user's operation (movement direction and movement amount) (Step S630).

Next, the volume level control receiving unit 22 moves the display positions of the respective channel faders 26 in the movement direction of the master fader 27 by the movement amount of the master fader 27 (Step S631). As a result, each channel fader 26 moves along with the movement of the master fader 27 in the movement direction of the master fader 27 while keeping the difference between the scale values indicated by the respective channel faders 26 (positional relationship among the channel faders 26-1 to 26-4).

Then, the volume level control receiving unit 22 identifies a scale value indicated by each channel fader 26, and for each channel fader 26, notifies the control signal outputting unit 23 of the scale value and address information on the wireless network-compatible speaker 1 associated with the channel fader 26. In response to this, for each channel fader 26, the control signal outputting unit 23 generates a control signal for adjusting the volume level of the associated wireless network-compatible speaker 1 to a volume level corresponding to the scale value received from the volume level control receiving unit 22, and transmits via the wireless network interface unit 20 the control signal to the wireless network-compatible speaker 1 that is identified by the address information received from the volume level control receiving unit 22 (Step S632). After that, the processing proceeds to Step S7 of FIG. 3.

On the other hand, in Step S610, when there is a channel fader 26 (in FIG. 7, the channel fader 26-4) that has reached the lower limit value of the corresponding scale 260 among the channel faders 26-1 to 26-4 and the minimum-value side end portion 271 of the master fader 27 has reached the lower limit value of the scale 270 as illustrated in FIG. 7 ("YES" in Step S610), the volume level control receiving unit 22 determines whether or not the master fader 27 has been operated through selection of the maximum-value side end portion 272 of the master fader 27 (Step S611). When any one of the channel faders 26 has reached the lower limit value of the scale 260, in order to allow the user to intuitively grasp the fact that the movement of the master fader 27 toward the lower limit value of the scale 270 is stopped, for example, a display mode (e.g., a color) of the master fader 27 or the maximum-value side end portion 272 of the master fader 27 may be changed, to thereby prompt the user to operate the maximum-value side end portion 272 of the master fader 27.

In Step S611, when the master fader 27 has not been operated through selection of the maximum-value side end portion 272 of the master fader 27 ("NO" in Step S611), the volume level control receiving unit 22 does not change the display of the respective channel faders 26 and the master fader 27, and the processing proceeds to Step S7 of FIG. 3. On the other hand, when the master fader 27 has been operated through selection of the maximum-value side end portion 272 of the master fader 27 ("YES" in Step S611), the volume level control receiving unit 22 updates the display position on the scale 270 of the maximum-value side end portion 272 of the master fader 27 in accordance with details of the user's operation (movement direction and movement amount) (Step S612). As a result, the width W of the master fader 27 is narrowed. In addition, the volume level control receiving unit 22 moves the display positions of all of the channel faders 26-1 to 26-3 other than the channel fader 26-4, which has reached the lower limit value of the corresponding scale 260, namely, the channel faders 26-1 to 26-3, which have not reached the lower limit value of the corresponding scale 260, in the movement direction of the maximum-value side end portion 272 of the master fader 27 by the movement amount of the maximum-value side end portion 272 of the master fader 27 (Step S613). When any one of the channel faders 26-1 to 26-3 reaches the position of the lower limit value of the corresponding scale 260 before finishing moving by the movement amount of the maximum-value side end portion 272 of the master fader 27, only other channel faders that have not reached the position of the lower limit value of the corresponding scale 260 continue to move.

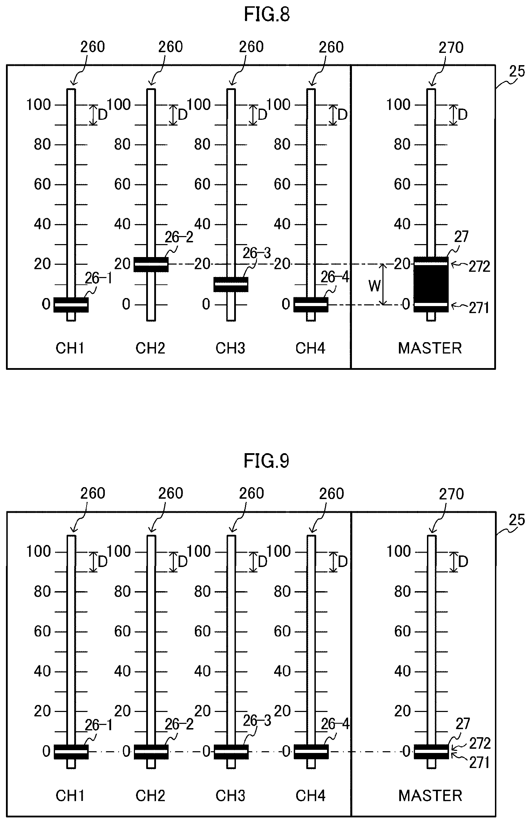

FIG. 8 is a diagram for schematically illustrating a state in which, on the control screen 25 illustrated in FIG. 7, the maximum-value side end portion 272 of the master fader 27 is operated to be moved toward the lower limit value of the scale 270 until the scale value indicated by the channel fader 26-1 reaches the lower limit value of the corresponding scale 260. As compared with FIG. 7, the width W of the master fader 27 is narrowed by an amount corresponding to the movement amount of the maximum-value side end portion 272 of the master fader 27. In addition, only the channel faders 26-1 to 26-3, which have not reached the lower limit value of the corresponding scale 260, have moved toward the lower limit value of the corresponding scale 260 by the movement amount of the maximum-value side end portion 272 of the master fader 27, and the scale value indicated by each of the channel faders 26-1 to 26-3 is reduced by a value corresponding to the movement amount.

FIG. 9 is a diagram for schematically illustrating a state in which, on the control screen 25 illustrated in FIG. 8, the maximum-value side end portion 272 of the master fader 27 is operated to be moved toward the lower limit value of the scale 270 until the scale value indicated by the channel fader 26-2 reaches the lower limit value of the corresponding scale 260. The maximum-value side end portion 272 of the master fader 27 is operated to be moved toward the lower limit value of the scale 270 until the channel fader 26-2 indicating the maximum scale value among the channel faders 26-1 to 26-4 reaches the position of the lower limit value of the corresponding scale 260. As a result, the scale values indicated by all of the channel faders 26-1 to 26-4 have reached the lower limit value of the corresponding scale 260. Further, the maximum-value side end portion 272 and the minimum-value side end portion 271 of the master fader 27 overlap each other to be displayed at the position of the lower limit value of the scale 270.

Next, the volume level control receiving unit 22 identifies a scale value indicated by each channel fader 26 on the corresponding scale 260, and for each channel fader 26, notifies the control signal outputting unit 23 of the scale value and address information on the wireless network-compatible speaker 1 associated with the channel fader 26. In response to this, for each channel fader 26, the control signal outputting unit 23 generates a control signal for adjusting the volume level of the associated wireless network-compatible speaker 1 to a volume level corresponding to the scale value received from the volume level control receiving unit 22, and transmits via the wireless network interface unit 20 the control signal to the wireless network-compatible speaker 1 that is identified by the address information received from the volume level control receiving unit 22 (Step S632). At this time, the control signal may not be transmitted to the wireless network-compatible speaker 1 whose volume level is not to be changed. After that, the processing proceeds to Step S7 of FIG. 3.

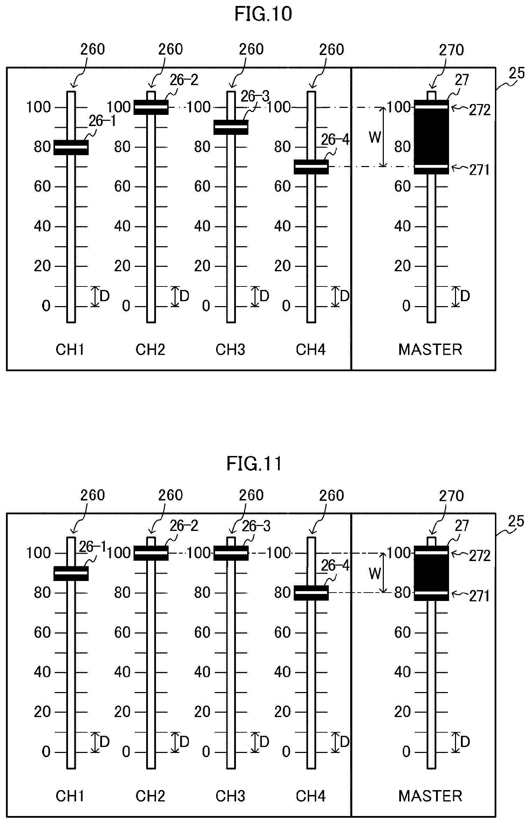

Further, in Step S620, when there is a channel fader 26 (in FIG. 10, the channel fader 26-2) whose scale value has reached the upper limit value of the scale 260 as illustrated in FIG. 10 ("YES" in Step S620), the volume level control receiving unit 22 determines whether or not the master fader 27 has been operated through selection of the minimum-value side end portion 271 of the master fader 27 (Step S621). When any one of the channel faders 26-1 to 26-4 has reached the upper limit value of the scale 260, in order to allow the user to intuitively grasp the fact that the movement of the master fader 27 toward the upper limit value of the scale 270 is stopped, for example, a display mode (e.g., a color) of the master fader 27 or the minimum-value side end portion 271 of the master fader 27 may be changed, to thereby prompt the user to operate the minimum-value side end portion 271 of the master fader 27.

In Step S621, when the master fader 27 has not been operated through selection of the minimum-value side end portion 271 of the master fader 27 ("NO" in Step S621), the volume level control receiving unit 22 does not change the display of the respective channel faders 26 and the master fader 27, and the processing proceeds to Step S7 of FIG. 3. On the other hand, when the master fader 27 has been operated through selection of the minimum-value side end portion 271 of the master fader 27 ("YES" in Step S621), the volume level control receiving unit 22 updates the display position on the scale 270 of the minimum-value side end portion 271 of the master fader 27 in accordance with details of the user's operation (movement direction and movement amount) (Step S622). As a result, the width W of the master fader 27 is narrowed. In addition, the volume level control receiving unit 22 moves the display positions of all of the channel faders 26-1, 26-3, and 26-4 other than the channel fader 26-2, which has reached the upper limit value of the corresponding scale 260, namely, the channel faders 26-1, 26-3, and 26-4, which have not reached the upper limit value of the corresponding scale 260, in the movement direction of the minimum-value side end portion 271 of the master fader 27 by the movement amount of the minimum-value side end portion 271 of the master fader 27 (Step S623). When any one of the channel faders 26-1, 26-3, and 26-4 reaches the position of the upper limit value of the corresponding scale 260 before finishing moving by the movement amount of the minimum-value side end portion 271 of the master fader 27, only other channel faders that have not reached the position of the upper limit value of the corresponding scale 260 continue to move.

FIG. 11 is a diagram for schematically illustrating a state in which, on the control screen 25 illustrated in FIG. 10, the minimum-value side end portion 271 of the master fader 27 is operated to be moved toward the upper limit value of the scale 270 until the scale value indicated by the channel fader 26-3 reaches the upper limit value of the corresponding scale 260. As compared with FIG. 10, the width W of the master fader 27 is narrowed by an amount corresponding to the movement amount of the minimum-value side end portion 271 of the master fader 27. In addition, only the channel faders 26-1, 26-3, and 26-4, which have not reached the upper limit value of the corresponding scale 260, have moved toward the upper limit value of the corresponding scale 260 by the movement amount of the minimum-value side end portion 271 of the master fader 27, and the scale value indicated by each of the channel faders 26-1, 26-3, and 26-4 is increased by a value corresponding to the movement amount.

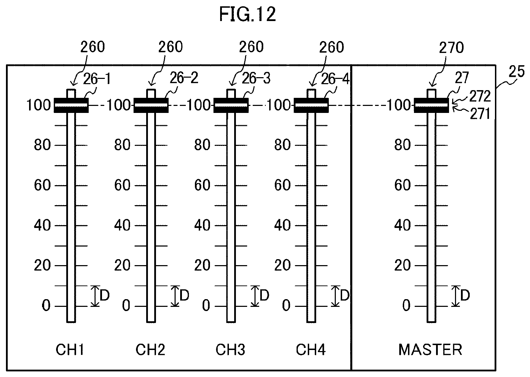

FIG. 12 is a diagram for schematically illustrating a state in which, on the control screen 25 illustrated in FIG. 11, the minimum-value side end portion 271 of the master fader 27 is operated to be moved toward the upper limit value of the scale 270 until the scale value indicated by the channel fader 26-4 reaches the upper limit value of the corresponding scale 260. The minimum-value side end portion 271 of the master fader 27 is operated to be moved toward the upper limit value of the scale 270 until the channel fader 26-4 indicating the minimum scale value among the channel faders 26-1 to 26-4 reaches the position of the upper limit value of the corresponding scale 260. As a result, the scale values indicated by all of the channel faders 26-1 to 26-4 have reached the upper limit value of the corresponding scale 260. Further, the minimum-value side end portion 271 and the maximum-value side end portion 272 of the master fader 27 overlap each other to be displayed at the position of the upper limit value of the scale 270.

Next, the volume level control receiving unit 22 identifies a scale value indicated by each channel fader 26, and for each channel fader 26, notifies the control signal outputting unit 23 of the scale value and address information on the wireless network-compatible speaker 1 associated with the channel fader 26. In response to this, for each channel fader 26, the control signal outputting unit 23 generates a control signal for adjusting the volume level of the associated wireless network-compatible speaker 1 to a volume level corresponding to the scale value received from the volume level control receiving unit 22, and transmits via the wireless network interface unit 20 the control signal to the wireless network-compatible speaker 1 that is identified by the address information received from the volume level control receiving unit 22 (Step S632). At this time, the control signal may not be transmitted to the wireless network-compatible speaker 1 whose volume level is not to be changed. After that, the processing proceeds to Step S7 of FIG. 3.

In the above, one embodiment of the present invention has been described.

In this embodiment, the minimum-value side end portion 271 of the master fader 27 is displayed at the position indicating the same scale value as the minimum value of the scale values indicated by the plurality of channel faders 26 in the control screen 25, respectively, and the maximum-value side end portion 272 of the master fader 27 is displayed at the position indicating the same scale value as the maximum value of the scale values indicated by the plurality of channel faders 26, respectively, such that the master fader 27 has the width W corresponding to the minimum value and the maximum value of the scale values indicated by those channel faders 26. With this configuration, when the channel fader 26 indicating the minimum scale value among the plurality of channel faders 26 in the control screen 25 reaches the position of the lower limit value of the corresponding scale 260, the minimum-value side end portion 271 of the master fader 27 also reaches the position of the lower limit value of the scale 270 (see FIG. 7), and when the channel fader 26 indicating the maximum scale value among the plurality of channel faders 26 in the control screen 25 reaches the position of the upper limit value of the corresponding scale 260, the maximum-value side end portion 272 of the master fader 27 also reaches the position of the upper limit value of the scale 270 (see FIG. 10). Accordingly, the master fader 27 can be moved to the position of the lower limit value and the upper limit value of the scale 270, and it is thus easy to intuitively grasp a range in which the master fader 27 is movable on the scale 270. Therefore, the operability of volume level control for the plurality of wireless network-compatible speakers 1 can be improved.

Further, in this embodiment, when the operation of moving the maximum-value side end portion 272 of the master fader 27 toward the lower limit value of the scale 270 is received under the state in which the minimum-value side end portion 271 of the master fader 27 has reached the position of the lower limit value of the scale 270, the channel faders 26 that have not reached the position of the lower limit value of the corresponding scale 260 among the plurality of channel faders 26 in the control screen 25 are moved toward the lower limit value of the corresponding scale 260 along with the movement of the maximum-value side end portion 272 of the master fader 27 (see FIG. 8 and FIG. 9). Accordingly, all of the channel faders 26 in the control screen 25 can be moved to the position of the lower limit value of the corresponding scale 260 only through the operation on the master fader 27, and it is not necessary to individually operate those channel faders 26. Therefore, the operability of volume level control for the plurality of wireless network-compatible speakers 1 can be further improved.

Still further, in this embodiment, when the operation of moving the minimum-value side end portion 271 of the master fader 27 toward the upper limit value of the scale 270 is received under the state in which the maximum-value side end portion 272 of the master fader 27 has reached the upper limit value of the scale 270, the channel faders 26 that have not reached the position of the upper limit value of the corresponding scale 260 among the plurality of channel faders 26 in the control screen 25 are moved toward the upper limit value of the corresponding scale 260 along with the movement of the minimum-value side end portion 271 of the master fader 27 (see FIG. 11 and FIG. 12). Accordingly, all of the channel faders 26 in the control screen 25 can be moved to the upper limit value of the corresponding scale 260 only through the operation on the master fader 27, and it is not necessary to individually operate those channel faders 26. Therefore, the operability of volume level control for the plurality of wireless network-compatible speakers 1 can be further improved.

The present invention is not limited to the above-mentioned embodiment, and various changes may be made thereto within the scope of the gist of the invention.

For example, in the embodiment described above, when the operation of moving the maximum-value side end portion 272 of the master fader 27 toward the lower limit value of the scale 270 is received under the state in which the minimum-value side end portion 271 of the master fader 27 has reached the lower limit value of the scale 270, the channel faders 26 that have not reached the position of the lower limit value of the corresponding scale 260 among the plurality of channel faders 26 in the control screen 25 are moved toward the lower limit value of the corresponding scale 260 along with the movement of the maximum-value side end portion 272 of the master fader 27. However, the present invention is not limited thereto. When a predetermined operation is performed on the master fader 27 under the state in which the minimum-value side end portion 271 of the master fader 27 has reached the lower limit value of the scale 270, every channel fader 26 that has not reached the position of the lower limit value of the scale 260 among the plurality of channel faders 26 in the control screen 25 may be moved to the lower limit value of the scale 260. The predetermined operation is, for example, operating the master fader 27 to temporarily separate the minimum-value side end portion 271 of the master fader 27 from the lower limit value of the scale 270 and then cause the minimum-value side end portion 271 to reach the lower limit value of the scale 270 again within a predetermined period of time, or double-clicking on the master fader 27. In this manner, operability in a case of a small display screen, for example, a touch panel of a smartphone, can be improved.

Further, in the embodiment described above, when the operation of moving the minimum-value side end portion 271 of the master fader 27 toward the upper limit value of the scale 270 is received under the state in which the maximum-value side end portion 272 of the master fader 27 has reached the position of the upper limit value of the scale 270, the channel faders 26 that have not reached the upper limit value of the corresponding scale 260 among the plurality of channel faders 26 in the control screen 25 are moved toward the upper limit value of the scale 260 along with the movement of the minimum-value side end portion 271 of the master fader 27. However, the present invention is not limited thereto. When a predetermined operation is performed on the master fader 27 under the state in which the maximum-value side end portion 272 of the master fader 27 has reached the upper limit value of the scale 270, every channel fader 26 that has not reached the position of the upper limit value of the scale 260 among the plurality of channel faders 26 in the control screen 25 may be moved to the upper limit value of the scale 260. The predetermined operation is, for example, operating the master fader 27 to temporarily separate the maximum-value side end portion 272 of the master fader 27 from the upper limit value of the scale 270 and then cause the maximum-value side end portion 272 to reach the upper limit value of the scale 270 again within a predetermined period of time, or double-clicking on the master fader 27. In this manner, operability in the case of a small display screen, for example, a touch panel of a smartphone, can be improved.

Further, in the embodiment described above, the case where the volume level control terminal 2 is connected to the wireless network via the access point 4 is taken as an example for description, but the volume level control terminal 2 may be connected directly to the network 5 without the wireless network.

Further, in the embodiment described above, the media server 3 is connected to the network 5, but the media server 3 may be connected to the wireless network via the access point 4. Further, the media server 3 may be built into the volume level control terminal 2, or may be built into any one of the wireless network-compatible speakers 1.

Further, in the embodiment described above, the case where the volume level control terminal 2 controls the volume level of the wireless network-compatible speaker 1 is taken as an example for description, but the present invention is widely applicable to a case where volume levels of various types of audio devices having an audio outputting function, such as speakers compatible with a wired network, are controlled.

Further, in the embodiment described above, the case where the four channel faders 26 are arranged in the control screen 25 is taken as an example, but the number of channel faders 26 to be arranged in the control screen 25 may be set as appropriate. Further, in the embodiment described above, all of the channel faders 26 in the control screen 25 move along with the master fader 27, but only any two or more channel faders 26 in the control screen 25 that are selected by the user may move along with the master fader 27.

### Reference Signs List

1, 1-1 to 1-4: wireless network-compatible speaker, 2: volume level control terminal, 3: media server, 4: access point, 5: network, 20: wireless network interface unit, 21: graphical user interface unit, 22: volume level control receiving unit, 23: control signal outputting unit, 25: control screen, 26, 26-1 to 26-4: channel fader, 27: master fader, 260: scale of channel fader 26, 270: scale of master fader 27, 271: minimum-value side end portion of master fader 27, 272: maximum-value side end portion of master fader 27

## Claims

1. A method for adjusting volume levels of a plurality of audio devices, the method comprising:
displaying, on a graphical user interface, a control screen including:
a plurality of channel faders (26) for individually receiving volume level control for the plurality of audio devices; and
a master fader (27) for collectively receiving volume level control for the plurality of audio devices;
outputting, for each of the plurality of channel faders, a control signal for adjusting a volume level of one of the plurality of audio devices associated with the each of the plurality of channel faders to a volume level corresponding to a scale value indicated by the each of the plurality of channel faders;
wherein the master fader has a width corresponding to a minimum value and a maximum value of the scale values indicated by the plurality of channel faders, respectively;
wherein the master fader has a minimum-value side end portion (271) displayed at a position indicating the same scale value as the minimum value and has a maximum-value side end portion (272) displayed at a position indicating the same scale value as the maximum value, the minimum-value side end portion being one end portion of the master fader, the maximum-value side end portion being another end portion of the master fader;
moving, in the control screen (25), the plurality of channel faders in the same direction as a movement direction of the master fader along with movement of the master fader while keeping a difference between the scale values indicated by the plurality of channel faders;
wherein the movement of the master fader is controlled by a user via the graphical user interface;
when a first predetermined operation is performed on the master fader by the user via the graphical user interface after the minimum-value side end portion of the master fader is at the lower limit value of the scale, each of the plurality of channel faders that has not reached the position of the lower limit value of the scale is moved to the lower limit value of the scale in the control screen,
wherein the first predetermined operation comprises either:
i) a double-click on the master fader; or
ii) temporarily separating the minimum-value side end portion of the master fader from the lower limit value of the scale and then cause the minimum-value side end portion to reach the lower limit value of the scale again within a predetermined period of time; and
when a second predetermined operation is performed on the master fader by the user via the graphical user interface after the maximum-value side end portion of the master fader is at the upper limit value of the scale, each of the plurality of channel faders that has not reached the position of the upper limit value of the scale is moved to the upper limit value of the scale in the control screen, wherein the second predetermined operation comprises either:
i) a double-click on the master fader; or
ii) temporarily separating the maximum-value side end portion of the master fader from the upper limit value of the scale and then cause the maximum-value side end portion to reach the upper limit value of the scale again within a predetermined period of time.

2. The method of Claim 1, wherein the first predetermined operation comprises a double-click on the master fader, and wherein the second predetermined operation comprises a double-click on the master fader.

3. The method of Claim 1, wherein:
the first predetermined operation comprises temporarily separating the minimum-value side end portion of the master fader from the lower limit value of the scale and then cause the minimum-value side end portion to reach the lower limit value of the scale again within a predetermined period of time; and
the second predetermined operation comprises temporarily separating the maximum-value side end portion of the master fader from the upper limit value of the scale and then cause the maximum-value side end portion to reach the upper limit value of the scale again within a predetermined period of time.

4. The method of any one of Claims 1 to 3, comprising changing a display mode of the master fader when any one of the plurality of channel faders has reached the lower limit value of the scale, or changing the display mode of the master fader when any one of the plurality of channel faders has reached the upper limit value of the scale.

5. The method of Claim 4, wherein changing the display mode of the master fader comprises changing the color of the master fader.

6. A computer program comprising instructions which, when the program is executed by a computer, cause the computer to function as a volume level control device by:
displaying, on a graphical user interface, a control screen including:
a plurality of channel faders (26) for individually receiving volume level control for the plurality of audio devices; and
a master fader (27) for collectively receiving volume level control for the plurality of audio devices;
outputting, for each of the plurality of channel faders, a control signal for adjusting a volume level of one of the plurality of audio devices associated with the each of the plurality of channel faders to a volume level corresponding to a scale value indicated by the each of the plurality of channel faders;
wherein the master fader has a width corresponding to a minimum value and a maximum value of the scale values indicated by the plurality of channel faders, respectively;
wherein the master fader has a minimum-value side end portion (271) displayed at a position indicating the same scale value as the minimum value and has a maximum-value side end portion (272) displayed at a position indicating the same scale value as the maximum value, the minimum-value side end portion being one end portion of the master fader, the maximum-value side end portion being another end portion of the master fader;
moving, in the control screen (25), the plurality of channel faders in the same direction as a movement direction of the master fader along with movement of the master fader while keeping a difference between the scale values indicated by the plurality of channel faders;
wherein the movement of the master fader is controlled by a user via the graphical user interface;
when a first predetermined operation is performed on the master fader by the user via the graphical user interface after the minimum-value side end portion of the master fader is at the lower limit value of the scale, each of the plurality of channel faders that has not reached the position of the lower limit value of the scale is moved to the lower limit value of the scale in the control screen, wherein the first predetermined operation comprises either:
i) a double-click on the master fader; or
ii) temporarily separating the minimum-value side end portion of the master fader from the lower limit value of the scale and then cause the minimum-value side end portion to reach the lower limit value of the scale again within a predetermined period of time; and
when a second predetermined operation is performed on the master fader by the user via the graphical user interface after the maximum-value side end portion of the master fader is at the upper limit value of the scale, each of the plurality of channel faders that has not reached the position of the upper limit value of the scale is moved to the upper limit value of the scale in the control screen, wherein the second predetermined operation comprises either:
i) a double-click on the master fader; or
ii) temporarily separating the maximum-value side end portion of the master fader from the upper limit value of the scale and then cause the maximum-value side end portion to reach the upper limit value of the scale again within a predetermined period of time.

7. The program readable by a computer of Claim 6, wherein the first predetermined operation comprises a double-click on the master fader, and wherein the second predetermined operation comprises a double-click on the master fader.

8. The program readable by a computer of Claim 6, wherein:
the first predetermined operation comprises temporarily separating the minimum-value side end portion of the master fader from the lower limit value of the scale and then cause the minimum-value side end portion to reach the lower limit value of the scale again within a predetermined period of time; and
the second predetermined operation comprises temporarily separating the maximum-value side end portion of the master fader from the upper limit value of the scale and then cause the maximum-value side end portion to reach the upper limit value of the scale again within a predetermined period of time.

9. The program readable by a computer of any one of Claims 6 to 8, wherein the program is configured to cause the computer to change a display mode of the master fader when any one of the plurality of channel faders has reached the lower limit value of the scale, and to change the display mode of the master fader when any one of the plurality of channel faders has reached the upper limit value of the scale.

10. The program readable by a computer of Claim 9, wherein changing the display mode of the master fader comprises changing the color of the master fader.

11. A volume level control device, which is configured to adjust volume levels of a plurality of audio devices, the volume level control device comprising:
a display for displaying, on a graphical user interface, a control screen including:
a plurality of channel faders (26) for individually receiving volume level control for the plurality of audio devices; and
a master fader (27) for collectively receiving volume level control for the plurality of audio devices;
an output for outputting, for each of the plurality of channel faders, a control signal for adjusting a volume level of one of the plurality of audio devices associated with the each of the plurality of channel faders to a volume level corresponding to a scale value indicated by the each of the plurality of channel faders;
wherein the master fader has a width corresponding to a minimum value and a maximum value of the scale values indicated by the plurality of channel faders, respectively;
wherein the master fader has a minimum-value side end portion (271) displayed at a position indicating the same scale value as the minimum value and has a maximum-value side end portion (272) displayed at a position indicating the same scale value as the maximum value, the minimum-value side end portion being one end portion of the master fader, the maximum-value side end portion being another end portion of the master fader; and
a controller configured to move, in the control screen (25), the plurality of channel faders in the same direction as a movement direction of the master fader along with movement of the master fader while keeping a difference between the scale values indicated by the plurality of channel faders;
wherein the graphical user interface is configured to provide user control over the movement of the master fader;
wherein the controller is configured to move each of the plurality of channel faders that has not reached the position of the lower limit value of the scale is moved to the lower limit value of the scale in the control screen when a first predetermined operation is performed on the master fader by the user via the graphical user interface after the minimum-value side end portion of the master fader is at the lower limit value of the scale, wherein the first predetermined operation comprises either:
i) a double-click on the master fader; or
ii) temporarily separating the minimum-value side end portion of the master fader from the lower limit value of the scale and then cause the minimum-value side end portion to reach the lower limit value of the scale again within a predetermined period of time; and
wherein the controller is configured to move each of the plurality of channel faders that has not reached the position of the upper limit value of the scale to the upper limit value of the scale in the control screen when a second predetermined operation is performed on the master fader by the user via the graphical user interface after the maximum-value side end portion of the master fader is at the upper limit value of the scale, wherein the second predetermined operation comprises either:
i) a double-click on the master fader; or
ii) temporarily separating the maximum-value side end portion of the master fader from the upper limit value of the scale and then cause the maximum-value side end portion to reach the upper limit value of the scale again within a predetermined period of time.

12. The volume level control device of Claim 11, wherein the first predetermined operation comprises a double-click on the master fader, and wherein the second predetermined operation comprises a double-click on the master fader.

13. The volume level control device of Claim 11, wherein:
the first predetermined operation comprises temporarily separating the minimum-value side end portion of the master fader from the lower limit value of the scale and then cause the minimum-value side end portion to reach the lower limit value of the scale again within a predetermined period of time; and
the second predetermined operation comprises temporarily separating the maximum-value side end portion of the master fader from the upper limit value of the scale and then cause the maximum-value side end portion to reach the upper limit value of the scale again within a predetermined period of time.

14. The volume level control device of any one of Claims 11 to 13, configured to change a display mode of the master fader when any one of the plurality of channel faders has reached the lower limit value of the scale, and to change the display mode of the master fader when any one of the plurality of channel faders has reached the upper limit value of the scale.

15. The program readable by a computer of Claim 14, wherein changing the display mode of the master fader comprises changing the color of the master fader.

## Patentansprüche

1. Verfahren zum Einstellen von Lautstärkepegeln einer Vielzahl von Audiovorrichtungen, wobei das Verfahren Folgendes umfasst:
Anzeigen, auf einer grafischen Benutzeroberfläche, eines Steuerbildschirms, umfassend:
eine Vielzahl von Kanal-Fadern (26) zum individuellen Empfangen einer Lautstärkepegelsteuerung für die Vielzahl von Audiovorrichtungen; und
einen Master-Fader (27) zum kollektiven Empfangen einer Lautstärkepegelsteuerung für die Vielzahl von Audiovorrichtungen;
Ausgeben, für jeden aus der Vielzahl von Kanal-Fadern, eines Steuersignals zum Einstellen eines Lautstärkepegels von einer aus der Vielzahl von Audiovorrichtungen, der jedem aus der Vielzahl von Kanal-Fadern zugeordnet ist, auf einen Lautstärkepegel, der einem Skalenwert entspricht, der durch jeden aus der Vielzahl von Kanal-Fadern angegeben ist;
wobei der Master-Fader eine Breite aufweist, die jeweils einem Mindestwert und einem Höchstwert der Skalenwerte entspricht, die jeweils von der Vielzahl von Kanal-Fadern angegeben sind;
wobei der Master-Fader einen Mindestwert-seitigen Endabschnitt (271) aufweist, der in einer Position angezeigt wird, die den gleichen Skalenwert wie der Mindestwert angibt, und einen Höchstwert-seitigen Endabschnitt (272) aufweist, der in einer Position angezeigt wird, die den gleichen Skalenwert wie der Höchstwert angibt, wobei der Mindestwert-seitige Endabschnitt ein Endabschnitt des Master-Faders ist, wobei der Höchstwert-seitige Endabschnitt ein anderer Endabschnitt des Master-Faders ist;
Bewegen, im Steuerbildschirm (25), der Vielzahl von Kanal-Fadern in dieselbe Richtung wie eine Bewegungsrichtung des Master-Faders zusammen mit der Bewegung des Master-Faders, während eine Differenz zwischen den Skalenwerten, die durch die Vielzahl von Kanal-Fadern angegeben sind, beibehalten wird;
wobei das Bewegen des Master-Faders durch einen Benutzer über die grafische Benutzeroberfläche gesteuert wird;
wenn durch den Benutzer über die grafische Benutzeroberfläche ein erster vorbestimmter Vorgang an dem Master-Fader durchgeführt wird, nachdem der Mindestwert-seitige Endabschnitt des Master-Fader an dem unteren Grenzwert der Skala ist, jeder aus der Vielzahl von Kanal-Fadern, der die Position des unteren Grenzwerts der Skala nicht erreicht hat, zu dem unteren Grenzwert der Skala in dem Steuerbildschirm bewegt wird,
wobei der erste vorbestimmte Vorgang Folgendes umfasst:
i) entweder einen Doppelklick auf den Master-Fader; oder
ii) ein vorübergehendes Trennen des Mindestwert-seitigen Endabschnitts des Master-Faders von dem unteren Grenzwert der Skala und anschließend das Bewirken, dass der Mindestwert-seitige Endabschnitt den unteren Grenzwert der Skala innerhalb eines vorbestimmten Zeitraums wieder erreicht; und
wenn durch den Benutzer über die grafische Benutzeroberfläche ein zweiter vorbestimmter Vorgang an dem Master-Fader durchgeführt wird, nachdem der Höchstwert-seitige Endabschnitt des Master-Fader an dem oberen Grenzwert der Skala ist, jeder aus der Vielzahl von Kanal-Fadern, der die Position des oberen Grenzwerts der Skala nicht erreicht hat, zu dem oberen Grenzwert der Skala in dem Steuerbildschirm bewegt wird, wobei der zweite vorbestimmte Vorgang Folgendes umfasst:
i) entweder einen Doppelklick auf den Master-Fader;
ii) oder ein vorübergehendes Trennen des Höchstwert-seitigen Endabschnitts des Master-Faders von dem oberen Grenzwert der Skala und anschließend das Bewirken, dass der Höchstwert-seitige Endabschnitt den oberen Grenzwert der Skala innerhalb eines vorbestimmten Zeitraums wieder erreicht.

2. Verfahren nach Anspruch 1, wobei der erste vorbestimmte Vorgang einen Doppelklick auf den Master-Fader umfasst und wobei der zweite vorbestimmte Vorgang einen Doppelklick auf den Master-Fader umfasst.

3. Verfahren nach Anspruch 1, wobei:
der erste vorbestimmte Vorgang ein vorübergehendes Trennen des Mindestwert-seitigen Endabschnitts des Master-Faders von dem unteren Grenzwert der Skala und anschließend das Bewirken, dass der Mindestwert-seitige Endabschnitt den unteren Grenzwert der Skala innerhalb eines vorbestimmten Zeitraums wieder erreicht, umfasst; und
der zweite vorbestimmte Vorgang ein vorübergehendes Trennen des Höchstwert-seitigen Endabschnitts des Master-Faders von dem oberen Grenzwert der Skala und anschließend das Bewirken, dass der Höchstwert-seitige Endabschnitt den oberen Grenzwert der Skala innerhalb eines vorbestimmten Zeitraums wieder erreicht, umfasst.

4. Verfahren nach einem der Ansprüche 1 bis 3, umfassend das Ändern eines Anzeigemodus des Master-Faders, wenn einer aus der Vielzahl von Kanal-Fadern den unteren Grenzwert der Skala erreicht hat, oder das Ändern des Anzeigemodus des Master-Faders, wenn einer aus der Vielzahl von Kanal-Fadern den oberen Grenzwert der Skala erreicht hat.

5. Verfahren nach Anspruch 4, wobei das Ändern des Anzeigemodus des Master-Faders das Ändern der Farbe des Master-Faders umfasst.

6. Computerprogramm, das Befehle umfasst, die, wenn das Programm durch einen Computer ausgeführt wird, bewirkt, dass der Computer als Lautstärkepegelsteuervorrichtung funktioniert, durch:
Anzeigen, auf einer grafischen Benutzeroberfläche, eines Steuerbildschirms, umfassend:
eine Vielzahl von Kanal-Fadern (26) zum individuellen Empfangen einer Lautstärkepegelsteuerung für die Vielzahl von Audiovorrichtungen; und
einen Master-Fader (27) zum kollektiven Empfangen einer Lautstärkepegelsteuerung für die Vielzahl von Audiovorrichtungen;
Ausgeben, für jeden aus der Vielzahl von Kanal-Fadern, eines Steuersignals zum Einstellen eines Lautstärkepegels von einer aus der Vielzahl von Audiovorrichtungen, der jedem aus der Vielzahl von Kanal-Fadern zugeordnet ist, an einen Lautstärkepegel, der einem Skalenwert entspricht, der durch jeden aus der Vielzahl von Kanal-Fadern angegeben ist;
wobei der Master-Fader eine Breite aufweist, die jeweils einem Mindestwert und einem Höchstwert der Skalenwerte entspricht, die jeweils von der Vielzahl von Kanal-Fadern angegeben sind;
wobei der Master-Fader einen Mindestwert-seitigen Endabschnitt (271) aufweist, der in einer Position angezeigt wird, die den gleichen Skalenwert wie der Mindestwert angibt, und einen Höchstwert-seitigen Endabschnitt (272) aufweist, der in einer Position angezeigt wird, die den gleichen Skalenwert wie der Höchstwert angibt, wobei der Mindestwert-seitige Endabschnitt ein Endabschnitt des Master-Faders ist, wobei der Höchstwert-seitige Endabschnitt ein anderer Endabschnitt des Master-Faders ist;
Bewegen, im Steuerbildschirm (25), der Vielzahl von Kanal-Fadern in dieselbe Richtung wie eine Bewegungsrichtung des Master-Faders zusammen mit der Bewegung des Master-Faders, während ein Unterschied zwischen den Skalenwerten, die durch die Vielzahl von Kanal-Fadern angegeben sind, beibehalten wird;
wobei das Bewegen des Master-Faders durch einen Benutzer über die grafische Benutzeroberfläche gesteuert wird;
wenn durch den Benutzer über die grafische Benutzeroberfläche ein erster vorbestimmter Vorgang an dem Master-Fader durchgeführt wird, nachdem der Mindestwert-seitige Endabschnitt des Master-Fader an dem unteren Grenzwert der Skala ist, jeder aus der Vielzahl von Kanal-Fadern, der die Position des unteren Grenzwerts der Skala nicht erreicht hat, zu dem unteren Grenzwert der Skala in dem Steuerbildschirm bewegt wird,
wobei der erste vorbestimmte Vorgang Folgendes umfasst:
i) entweder einen Doppelklick auf den Master-Fader; oder
ii) ein vorübergehendes Trennen des Mindestwert-seitigen Endabschnitts des Master-Faders von dem unteren Grenzwert der Skala und anschließend das Bewirken, dass der Mindestwert-seitige Endabschnitt den unteren Grenzwert der Skala innerhalb eines vorbestimmten Zeitraums wieder erreicht; und
wenn durch den Benutzer über die grafische Benutzeroberfläche ein zweiter vorbestimmter Vorgang an dem Master-Fader durchgeführt wird, nachdem der Höchstwert-seitige Endabschnitt des Master-Fader an dem oberen Grenzwert der Skala ist, jeder aus der Vielzahl von Kanal-Fadern, der die Position des oberen Grenzwerts der Skala nicht erreicht hat, zu dem oberen Grenzwert der Skala in dem Steuerbildschirm bewegt wird, wobei der zweite vorbestimmte Vorgang Folgendes umfasst:
i) entweder einen Doppelklick auf den Master-Fader; oder
ii) ein vorübergehendes Trennen des Höchstwert-seitigen Endabschnitts des Master-Faders von dem oberen Grenzwert der Skala und anschließend das Bewirken, dass der Höchstwert-seitige Endabschnitt den oberen Grenzwert der Skala innerhalb eines vorbestimmten Zeitraums wieder erreicht.

7. Programm, das durch einen Computer nach Anspruch 6 lesbar ist, wobei der erste vorbestimmte Vorgang einen Doppelklick auf den Master-Fader umfasst und wobei der zweite vorbestimmte Vorgang einen Doppelklick auf den Master-Fader umfasst.

8. Programm, das durch einen Computer nach Anspruch 6 lesbar ist, wobei:
der erste vorbestimmte Vorgang ein vorübergehendes Trennen des Mindestwert-seitigen Endabschnitts des Master-Faders von dem unteren Grenzwert der Skala und anschließend das Bewirken, dass der Mindestwert-seitige Endabschnitt den unteren Grenzwert der Skala innerhalb eines vorbestimmten Zeitraums wieder erreicht, umfasst; und
der zweite vorbestimmte Vorgang ein vorübergehendes Trennen des Höchstwert-seitigen Endabschnitts des Master-Faders von dem oberen Grenzwert der Skala und anschließend das Bewirken, dass der Höchstwert-seitige Endabschnitt den oberen Grenzwert der Skala innerhalb eines vorbestimmten Zeitraums wieder erreicht, umfasst.

9. Programm, das durch einen Computer nach einem der Ansprüche 6 bis 8 lesbar ist, wobei das Programm konfiguriert ist, um zu bewirken, dass der Computer einen Anzeigemodus des Master-Faders ändert, wenn einer aus der Vielzahl von Kanal-Fadern den unteren Grenzwert der Skala erreicht hat, und den Anzeigemodus des Master-Faders ändert, wenn einer aus der Vielzahl von Kanal-Fadern den oberen Grenzwert der Skala erreicht hat.

10. Programm, das durch einen Computer nach Anspruch 9 lesbar ist, wobei das Ändern des Anzeigemodus des Master-Faders das Ändern der Farbe des Master-Faders umfasst.

11. Lautstärkepegelsteuervorrichtung, die dazu ausgelegt ist, Lautstärkepegel einer Vielzahl von Audiovorrichtungen anzupassen, wobei die Lautstärkepegelsteuervorrichtung Folgendes umfasst:
eine Anzeige zum Anzeigen, auf einer grafischen Benutzeroberfläche, eines Steuerbildschirms, umfassend:
eine Vielzahl von Kanal-Fadern (26) zum individuellen Empfangen einer Lautstärkepegelsteuerung für die Vielzahl von Audiovorrichtungen; und
einen Master-Fader (27) zum kollektiven Empfangen einer Lautstärkepegelsteuerung für die Vielzahl von Audiovorrichtungen;
einen Ausgang zum Ausgeben, für jeden aus der Vielzahl von Kanal-Fadern, eines Steuersignals zum Einstellen eines Lautstärkepegels von einer aus der Vielzahl von Audiovorrichtungen, der jedem aus der Vielzahl von Kanal-Fadern zugeordnet ist, an einen Lautstärkepegel, der einem Skalenwert entspricht, der durch jeden aus der Vielzahl von Kanal-Fadern angegeben ist;
wobei der Master-Fader eine Breite aufweist, die jeweils einem Mindestwert und einem Höchstwert der Skalenwerte entspricht, die jeweils von der Vielzahl von Kanal-Fadern angegeben sind;
wobei der Master-Fader einen Mindestwert-seitigen Endabschnitt (271) aufweist, der in einer Position angezeigt wird, die den gleichen Skalenwert wie der Mindestwert angibt, und einen Höchstwert-seitigen Endabschnitt (272) aufweist, der in einer Position angezeigt wird, die den gleichen Skalenwert wie der Höchstwert angibt, wobei der Mindestwert-seitige Endabschnitt ein Endabschnitt des Master-Faders ist, wobei der Höchstwert-seitige Endabschnitt ein anderer Endabschnitt des Master-Faders ist;
eine Steuerung, die konfiguriert ist, um im Steuerbildschirm (25) die Vielzahl von Kanal-Fadern in dieselbe Richtung wie eine Bewegungsrichtung des Master-Faders zusammen mit einer Bewegung des Master-Faders zu bewegen, während ein Unterschied zwischen den Skalenwerten, die durch die Vielzahl von Kanal-Fadern angegeben sind, beibehalten wird;
wobei die grafische Benutzeroberfläche konfiguriert ist, um eine Benutzersteuerung über das Bewegen des Master-Faders bereitzustellen;
wobei die Steuerung konfiguriert ist, um jeden aus der Vielzahl von Kanal-Fadern, der die Position des unteren Grenzwerts der Skala nicht erreicht hat, zu dem unteren Grenzwert der Skala in dem Steuerbildschirm zu bewegen, wenn durch den Benutzer über die grafische Benutzeroberfläche ein erster vorbestimmter Vorgang an dem Master-Fader durchgeführt wird, nachdem der Mindestwert-seitige Endabschnitt des Master-Fader an dem unteren Grenzwert der Skala ist, bewegt wird,
wobei der erste vorbestimmte Vorgang Folgendes umfasst:
i) entweder einen Doppelklick auf den Master-Fader; oder
ii) ein vorübergehendes Trennen des Mindestwert-seitigen Endabschnitts des Master-Faders von dem unteren Grenzwert der Skala und anschließend das Bewirken, dass der Mindestwert-seitige Endabschnitt den unteren Grenzwert der Skala innerhalb eines vorbestimmten Zeitraums wieder erreicht; und
wobei die Steuerung konfiguriert ist, um jeden aus der Vielzahl von Kanal-Fadern, der die Position des oberen Grenzwerts der Skala nicht erreicht hat, zu dem oberen Grenzwert der Skala in dem Steuerbildschirm zu bewegen, wenn durch den Benutzer über die grafische Benutzeroberfläche ein zweiter vorbestimmter Vorgang an dem Master-Fader durchgeführt wird, nachdem sich der Höchstwert-seitige Endabschnitt des Master-Fader an dem oberen Grenzwert der Skala befindet, wobei der zweite vorbestimmte Vorgang Folgendes umfasst:
i) entweder einen Doppelklick auf den Master-Fader; oder
ii) ein vorübergehendes Trennen des Höchstwert-seitigen Endabschnitts des Master-Faders von dem oberen Grenzwert der Skala und anschließend das Bewirken, dass der Höchstwert-seitige Endabschnitt den oberen Grenzwert der Skala innerhalb eines vorbestimmten Zeitraums wieder erreicht.

12. Lautstärkepegelsteuervorrichtung nach Anspruch 11, wobei der erste vorbestimmte Vorgang einen Doppelklick auf den Master-Fader umfasst und wobei der zweite vorbestimmte Vorgang einen Doppelklick auf den Master-Fader umfasst.

13. Lautstärkepegelsteuervorrichtung nach Anspruch 11, wobei:
der erste vorbestimmte Vorgang ein vorübergehendes Trennen des Mindestwert-seitigen Endabschnitts des Master-Faders von dem unteren Grenzwert der Skala und anschließend das Bewirken, dass der Mindestwert-seitige Endabschnitt den unteren Grenzwert der Skala innerhalb eines vorbestimmten Zeitraums wieder erreicht, umfasst; und
der zweite vorbestimmte Vorgang ein vorübergehendes Trennen des Höchstwert-seitigen Endabschnitts des Master-Faders von dem oberen Grenzwert der Skala und anschließend das Bewirken, dass der Höchstwert-seitige Endabschnitt den oberen Grenzwert der Skala innerhalb eines vorbestimmten Zeitraums wieder erreicht, umfasst.

14. Lautstärkepegelsteuervorrichtung nach einem der Ansprüche 11 bis 13, die konfiguriert ist, um zu bewirken, dass der Computer einen Anzeigemodus des Master-Faders ändert, wenn einer aus der Vielzahl von Kanal-Fadern den unteren Grenzwert der Skala erreicht hat, und den Anzeigemodus des Master-Faders ändert, wenn einer aus der Vielzahl von Kanal-Fadern den oberen Grenzwert der Skala erreicht hat.

15. Programm, das durch einen Computer nach Anspruch 14 lesbar ist, wobei das Ändern des Anzeigemodus des Master-Faders das Ändern der Farbe des Master-Faders umfasst.

## Revendications

1. Procédé pour ajuster des niveaux de volume d'une pluralité de dispositifs audio, le procédé comprenant les étapes consistant à :
afficher, sur une interface utilisateur graphique, un écran de commande incluant :
une pluralité d'atténuateurs de canal (26) pour recevoir individuellement une commande de niveau de volume pour la pluralité de dispositifs audio ; et
un atténuateur principal (27) pour recevoir collectivement une commande de niveau de volume pour la pluralité de dispositifs audio ;
délivrer en sortie, pour chacun de la pluralité d'atténuateurs de canal, un signal de commande pour ajuster un niveau de volume d'un de la pluralité de dispositifs audio associés à chacun de la pluralité d'atténuateurs de canal à un niveau de volume correspondant à une valeur d'échelle indiquée par chacun de la pluralité d'atténuateurs de canal ;
dans lequel l'atténuateur principal présente une largeur correspondant à une valeur minimale et une valeur maximale des valeurs d'échelle indiquées par la pluralité d'atténuateurs de canal, respectivement ;
dans lequel l'atténuateur principal présente une partie d'extrémité côté valeur minimale (271) affichée à une position indiquant la même valeur d'échelle que la valeur minimale et présente une partie d'extrémité côté valeur maximale (272) affichée à une position indiquant la même valeur d'échelle que la valeur maximale, la partie d'extrémité côté valeur minimale étant une partie d'extrémité de l'atténuateur principal, la partie d'extrémité côté valeur maximale étant une autre partie d'extrémité de l'atténuateur principal,
déplacer, dans l'écran de commande (25), la pluralité d'atténuateurs de canal dans la même direction qu'une direction de déplacement de l'atténuateur de canal principal avec un déplacement de l'atténuateur de canal principal tout en conservant une différence entre les valeurs d'échelle indiquées par la pluralité d'atténuateurs de canal,
dans lequel le déplacement de l'atténuateur principal est commandé par un utilisateur via l'interface utilisateur graphique ;
lorsqu'une première opération prédéterminée est effectuée sur l'atténuateur principal par l'utilisateur via l'interface utilisateur graphique après que la partie d'extrémité côté valeur minimale de l'atténuateur principal soit à la valeur de limite inférieure de l'échelle, chacun de la pluralité d'atténuateurs de canal qui n'a pas atteint la position de la valeur de limite inférieure de l'échelle est déplacé vers la valeur de limite inférieure de l'échelle dans l'écran de commande,
dans lequel la première opération prédéterminée comprend :
i) un double-clic sur l'atténuateur principal ; ou
ii) une séparation temporaire de la partie d'extrémité côté valeur minimale de l'atténuateur principal à partir de la valeur de limite inférieure de l'échelle, puis amener la partie d'extrémité côté valeur minimale à atteindre à nouveau la valeur de limite inférieure de l'échelle dans une période de temps prédéterminée ; et
lorsqu'une seconde opération prédéterminée est effectuée sur l'atténuateur principal par l'utilisateur via l'interface utilisateur graphique après que la partie d'extrémité côté valeur maximale de l'atténuateur principal soit à la valeur de limite supérieure de l'échelle, chacun de la pluralité d'atténuateurs de canal qui n'a pas atteint la position de la valeur de limite supérieure de l'échelle est déplacé vers la valeur de limite supérieure de l'échelle dans l'écran de commande, dans lequel la seconde opération prédéterminée comprend :
i) un double-clic sur l'atténuateur principal ; ou
ii) une séparation temporaire de la partie d'extrémité côté valeur maximale de l'atténuateur principal à partir de la valeur de limite supérieure de l'échelle, puis amener la partie d'extrémité côté valeur maximale à atteindre à nouveau la valeur de limite supérieure de l'échelle dans une période de temps prédéterminée.

2. Procédé selon la revendication 1, dans lequel la première opération prédéterminée comprend un double-clic sur l'atténuateur principal, et dans lequel la seconde opération prédéterminée comprend un double-clic sur l'atténuateur principal.

3. Procédé selon la revendication 1, dans lequel :
la première opération prédéterminée comprend une séparation temporaire de la partie d'extrémité côté valeur minimale de l'atténuateur principal à partir de la valeur de limite inférieure de l'échelle, puis amener la partie d'extrémité côté valeur minimale à atteindre à nouveau la valeur de limite inférieure de l'échelle dans une période de temps prédéterminée ; et
la seconde opération prédéterminée comprend une séparation temporaire de la partie d'extrémité côté valeur maximale de l'atténuateur principal à partir de la valeur de limite supérieure de l'échelle, puis amener la partie d'extrémité côté valeur maximale à atteindre à nouveau la valeur de limite supérieure de l'échelle dans une période de temps prédéterminée.

4. Procédé selon l'une quelconque des revendications 1 à 3, comprenant une modification d'un mode d'affichage de l'atténuateur principal lorsque l'un quelconque de la pluralité d'atténuateurs de canal a atteint la valeur de limite inférieure de l'échelle, ou une modification du mode d'affichage de l'atténuateur principal lorsque l'un quelconque de la pluralité d'atténuateurs de canal a atteint la valeur de limite supérieure de l'échelle.

5. Procédé selon la revendication 4, dans lequel la modification du mode d'affichage de l'atténuateur principal comprend une modification de la couleur de l'atténuateur principal.

6. Programme informatique comprenant des instructions qui, lorsque le programme est exécuté par un ordinateur, amènent l'ordinateur à fonctionner comme un dispositif de commande de niveau de volume par l'intermédiaire des étapes consistant à :
afficher, sur une interface utilisateur graphique, un écran de commande incluant :
une pluralité d'atténuateurs de canal (26) pour recevoir individuellement une commande de niveau de volume pour la pluralité de dispositifs audio ; et
un atténuateur principal (27) pour recevoir collectivement une commande de niveau de volume pour la pluralité de dispositifs audio ;
délivrer en sortie, pour chacun de la pluralité d'atténuateurs de canal, un signal de commande pour ajuster un niveau de volume d'un de la pluralité de dispositifs audio associés à chacun de la pluralité d'atténuateurs de canal à un niveau de volume correspondant à une valeur d'échelle indiquée par chacun de la pluralité d'atténuateurs de canal ;
dans lequel l'atténuateur principal présente une largeur correspondant à une valeur minimale et une valeur maximale des valeurs d'échelle indiquées par la pluralité d'atténuateurs de canal, respectivement ;
dans lequel l'atténuateur principal présente une partie d'extrémité côté valeur minimale (271) affichée à une position indiquant la même valeur d'échelle que la valeur minimale et présente une partie d'extrémité côté valeur maximale (272) affichée à une position indiquant la même valeur d'échelle que la valeur maximale, la partie d'extrémité côté valeur minimale étant une partie d'extrémité de l'atténuateur principal, la partie d'extrémité côté valeur maximale étant une autre partie d'extrémité de l'atténuateur principal,
déplacer, dans l'écran de commande (25), la pluralité d'atténuateurs de canal dans la même direction qu'une direction de déplacement de l'atténuateur de canal principal avec un déplacement de l'atténuateur de canal principal tout en conservant une différence entre les valeurs d'échelle indiquées par la pluralité d'atténuateurs de canal,
dans lequel le déplacement de l'atténuateur principal est commandé par un utilisateur via l'interface utilisateur graphique ;
lorsqu'une première opération prédéterminée est effectuée sur l'atténuateur principal par l'utilisateur via l'interface utilisateur graphique après que la partie d'extrémité côté valeur minimale de l'atténuateur principal soit à la valeur de limite inférieure de l'échelle, chacun de la pluralité d'atténuateurs de canal qui n'a pas atteint la position de la valeur de limite inférieure de l'échelle est déplacé vers la valeur de limite inférieure de l'échelle dans l'écran de commande, dans lequel la première opération prédéterminée comprend :
i) un double-clic sur l'atténuateur principal ; ou
ii) une séparation temporaire de la partie d'extrémité côté valeur minimale de l'atténuateur principal à partir de la valeur de limite inférieure de l'échelle, puis amener la partie d'extrémité côté valeur minimale à atteindre à nouveau la valeur de limite inférieure de l'échelle dans une période de temps prédéterminée ; et
lorsqu'une seconde opération prédéterminée est effectuée sur l'atténuateur principal par l'utilisateur via l'interface utilisateur graphique après que la partie d'extrémité côté valeur maximale de l'atténuateur principal soit à la valeur de limite supérieure de l'échelle, chacun de la pluralité d'atténuateurs de canal qui n'a pas atteint la position de la valeur de limite supérieure de l'échelle est déplacé vers la valeur de limite supérieure de l'échelle dans l'écran de commande, dans lequel la seconde opération prédéterminée comprend :
i) un double-clic sur l'atténuateur principal ; ou
ii) une séparation temporaire de la partie d'extrémité côté valeur maximale de l'atténuateur principal à partir de la valeur de limite supérieure de l'échelle, puis amener la partie d'extrémité côté valeur maximale à atteindre à nouveau la valeur de limite supérieure de l'échelle dans une période de temps prédéterminée.

7. Programme lisible par un ordinateur selon la revendication 6, dans lequel la première opération prédéterminée comprend un double-clic sur l'atténuateur principal, et dans lequel la seconde opération prédéterminée comprend un double-clic sur l'atténuateur principal.

8. Programme lisible par un ordinateur selon la revendication 6, dans lequel :
la première opération prédéterminée comprend une séparation temporaire de la partie d'extrémité côté valeur minimale de l'atténuateur principal à partir de la valeur de limite inférieure de l'échelle, puis amener la partie d'extrémité côté valeur minimale à atteindre à nouveau la valeur de limite inférieure de l'échelle dans une période de temps prédéterminée ; et
la seconde opération prédéterminée comprend une séparation temporaire de la partie d'extrémité côté valeur maximale de l'atténuateur principal à partir de la valeur de limite supérieure de l'échelle, puis amener la partie d'extrémité côté valeur maximale à atteindre à nouveau la valeur de limite supérieure de l'échelle dans une période de temps prédéterminée.

9. Programme lisible par un ordinateur selon l'une quelconque des revendications 6 à 8, dans lequel le programme est configuré pour amener l'ordinateur à modifier un mode d'affichage de l'atténuateur principal lorsque l'un quelconque de la pluralité d'atténuateurs de canal a atteint la valeur de limite inférieure de l'échelle, et à modifier le mode d'affichage de l'atténuateur principal lorsque l'un quelconque de la pluralité d'atténuateurs de canal a atteint la valeur de limite supérieure de l'échelle.

10. Programme lisible par un ordinateur selon la revendication 9, dans lequel la modification du mode d'affichage de l'atténuateur principal comprend une modification de la couleur de l'atténuateur principal.

11. Dispositif de commande de niveau de volume, qui est configuré pour ajuster des niveaux de volume d'une pluralité de dispositifs audio, le dispositif de commande de niveau de volume comprenant :
un dispositif d'affichage pour afficher, sur une interface utilisateur graphique, un écran de commande incluant :
une pluralité d'atténuateurs de canal (26) pour recevoir individuellement une commande de niveau de volume pour la pluralité de dispositifs audio ; et
un atténuateur principal (27) pour recevoir collectivement une commande de niveau de volume pour la pluralité de dispositifs audio ;
une sortie pour délivrer en sortie, pour chacun de la pluralité d'atténuateurs de canal, un signal de commande pour ajuster un niveau de volume d'un de la pluralité de dispositifs audio associés à chacun de la pluralité d'atténuateurs de canal à un niveau de volume correspondant à une valeur d'échelle indiquée par chacun de la pluralité d'atténuateurs de canal,
dans lequel l'atténuateur principal présente une largeur correspondant à une valeur minimale et une valeur maximale des valeurs d'échelle indiquées par la pluralité d'atténuateurs de canal, respectivement ;
dans lequel l'atténuateur principal présente une partie d'extrémité côté valeur minimale (271) affichée à une position indiquant la même valeur d'échelle que la valeur minimale et présente une partie d'extrémité côté valeur maximale (272) affichée à une position indiquant la même valeur d'échelle que la valeur maximale, la partie d'extrémité côté valeur minimale étant une partie d'extrémité de l'atténuateur principal, la partie d'extrémité côté valeur maximale étant une autre partie d'extrémité de l'atténuateur principal ; et
un dispositif de commande configuré pour déplacer, dans l'écran de commande, la pluralité d'atténuateurs de canal dans la même direction qu'une direction de déplacement de l'atténuateur de canal principal avec un déplacement de l'atténuateur de canal principal tout en conservant une différence entre les valeurs d'échelle indiquées par la pluralité d'atténuateurs de canal,
dans lequel l'interface utilisateur graphique est configurée pour fournir un commande utilisateur sur le déplacement de l'atténuateur principal ;
dans lequel le dispositif de commande est configuré pour déplacer chacun de la pluralité d'atténuateurs de canal qui n'a pas atteint la position de la valeur de limite inférieure de l'échelle vers la valeur de limite inférieure de l'échelle dans l'écran de commande lorsqu'une première opération prédéterminée est effectuée sur l'atténuateur principal par l'utilisateur via l'interface utilisateur graphique après que la partie d'extrémité côté valeur minimale de l'atténuateur principal soit à la valeur de limite inférieure de l'échelle, dans lequel la première opération prédéterminée comprend :
i) un double-clic sur l'atténuateur principal ; ou
ii) une séparation temporaire de la partie d'extrémité côté valeur minimale de l'atténuateur principal à partir de la valeur de limite inférieure de l'échelle, puis amener la partie d'extrémité côté valeur minimale à atteindre à nouveau la valeur de limite inférieure de l'échelle dans une période de temps prédéterminée ; et
dans lequel le dispositif de commande est configuré pour déplacer chacun de la pluralité d'atténuateurs de canal qui n'a pas atteint la position de la valeur de limite supérieure de l'échelle vers la valeur de limite supérieure de l'échelle dans l'écran de commande lorsqu'une seconde opération prédéterminée est effectuée sur l'atténuateur principal par l'utilisateur via l'interface utilisateur graphique après que la partie d'extrémité côté valeur maximale de l'atténuateur principal soit à la valeur de limite supérieure de l'échelle, dans lequel la seconde opération prédéterminée comprend :
i) un double-clic sur l'atténuateur principal ; ou
ii) une séparation temporaire de la partie d'extrémité côté valeur maximale de l'atténuateur principal à partir de la valeur de limite supérieure de l'échelle, puis amener la partie d'extrémité côté valeur maximale à atteindre à nouveau la valeur de limite supérieure de l'échelle dans une période de temps prédéterminée.

12. Dispositif de commande de niveau de volume selon la revendication 11, dans lequel la première opération prédéterminée comprend un double-clic sur l'atténuateur principal, et dans lequel la seconde opération prédéterminée comprend un double-clic sur l'atténuateur principal.

13. Dispositif de commande de niveau de volume selon la revendication 11, dans lequel :
la première opération prédéterminée comprend une séparation temporaire de la partie d'extrémité côté valeur minimale de l'atténuateur principal à partir de la valeur de limite inférieure de l'échelle, puis amener la partie d'extrémité côté valeur minimale à atteindre à nouveau la valeur de limite inférieure de l'échelle dans une période de temps prédéterminée ; et
la seconde opération prédéterminée comprend une séparation temporaire de la partie d'extrémité côté valeur maximale de l'atténuateur principal à partir de la valeur de limite supérieure de l'échelle, puis amener la partie d'extrémité côté valeur maximale à atteindre à nouveau la valeur de limite supérieure de l'échelle dans une période de temps prédéterminée.

14. Dispositif de commande de niveau de volume selon l'une quelconque des revendications 11 à 13, configuré pour modifier un mode d'affichage de l'atténuateur principal lorsque l'un quelconque de la pluralité d'atténuateurs de canal a atteint la valeur de limite inférieure de l'échelle, et pour modifier le mode d'affichage de l'atténuateur principal lorsque l'un quelconque de la pluralité d'atténuateurs de canal a atteint la valeur de limite supérieure de l'échelle.

15. Programme lisible par un ordinateur selon la revendication 14, dans lequel la modification du mode d'affichage de l'atténuateur principal comprend une modification de la couleur de l'atténuateur principal.
